Europäisches Patentamt

European Patent Office

Office européen des brevets

(11) Publication number: **0 422 796 A2**

# (12) EUROPEAN PATENT APPLICATION

(21) Application number: 90310510.4

(22) Date of filing: **26.09.90**

(51) Int. Cl.⁵: **H03H 21/00**

(30) Priority: **11.10.89 GB 8922903**

(43) Date of publication of application:
**17.04.91 Bulletin 91/16**

(84) Designated Contracting States:
**AT BE CH DE DK ES FR GR IT LI LU NL SE**

(71) Applicant: **GEC PLESSEY
TELECOMMUNICATIONS LIMITED
New Century Park P.O. Box 53
Coventry, CV3 1HJ(GB)**

(72) Inventor: **Dyer, Nigel Paul
"Glebelands", 1, St. Michael's
Church Road, Liverpool. L17 7BS(GB)**
Inventor: **Poole, Steven John
7, Chartley Green, Green Park
Swindon, Wiltshire(GB)**

(74) Representative: **MacKenzie, Ian Alastair
Robert et al
The General Electric Company, p.l.c. Central
Patent Department Wembley Office Hirst
Research Center East Lane
Wembley Middlesex HA9 7PP(GB)**

(54) **An adaptive FIR filter having restricted coefficient ranges.**

(57) The adaptive FIR filter comprises a foreground non adaptive filter and a background adaptive filter. The background filter has N tap stages, some of which have their coefficient values applied to a summator. The output of the summator is compared with a predetermined constant K and produces an update enable signal. This signal controls a switch which corrects the output of a discriminator. The discriminator compares the performance of the foreground and background filter, to either the foreground filter or the background filter to prevent the coefficient values of the foreground filter being updated by the background filter when the coefficient values of the background filter are unsatisfactory.

# AN ADAPTIVE FIR FILTER HAVING RESTRICTED COEFFICIENT RANGES

The present invention relates to an adaptive finite impulse response (FIR) filter having restricted coefficient ranges.

In a digital telecommunications network, the digital speech signals travelling in each direction of a speech connection are carried on separate transmission paths. At the subscriber interface these signals are converted to analogue signals and combined to be sent to and received from the subscriber apparatus over a 2 wire path. The combination/separation of these two signals is performed with a 2/4 wire converter. One of the functions of this converter is to prevent signals that are received over the telecommunications network from being retransmitted back over the network as unwanted echo.

Unfortunately, conventional time invarient techniques are limited in their ability to prevent unwanted echoes because they are only able to give good performance when the impedance presented to the 2/4 wire converter by the subscriber line lies within fairly narrow limits.

There is, therefore, increasing interest in the use of adaptive echo cancellers to reduce the level of unwanted echo that is returned into the network. These echo cancellers typically use digital filters whose coefficients adapt with time to reduce the level of unwanted echo. The echo cancellers use the information contained in the signals passing in each direction through the connection to update the values of the coefficients.

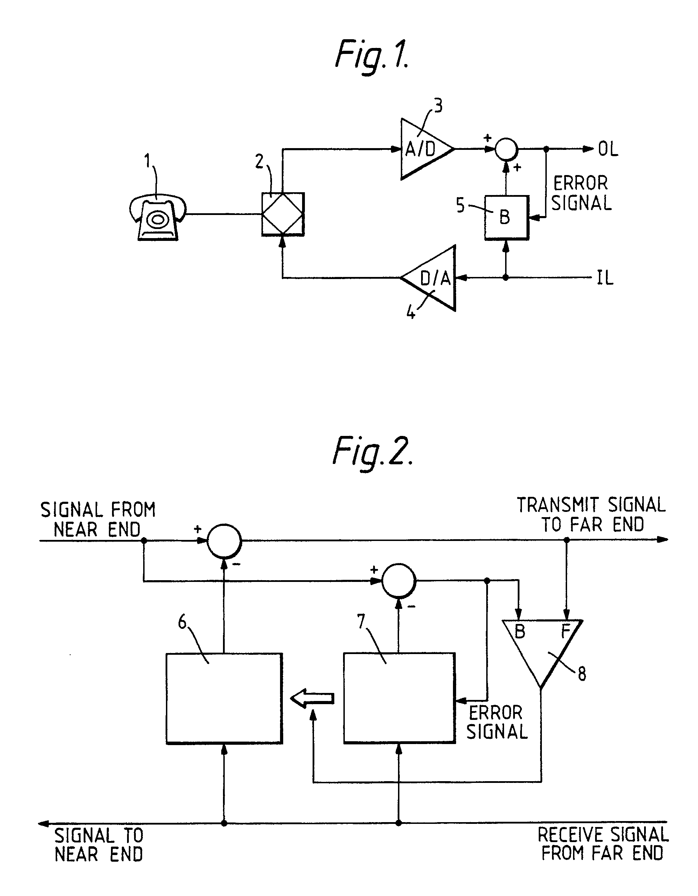

A diagram of a generalised subscriber interface incorporating adaptive balance is shown in Figure 1. A telephone 1 is shown connected by way of a near end 2/4 wire converter 2, and respective A/D, D/A converters 3,4 to the network, by way of outgoing and incoming lines OL, IL.

The purpose of the echo cancelling 'B' filter 5, is to remove the component of the far end signal that is returned to the network due to poor transhybrid loss through the 2/4 wire converter. The filter adaption algorithm is usually based on the least mean squares (LMS) algorithm.

The general approach is to update the values of the coefficients in the filter to minimise the amplitude of the signal that is transmitted back to the network, which contains the unwanted echo. This signal is referred to as the error signal.

An extension of this approach is described in US patent 3787645 filed by NEC in May 1972. This patent uses a foreground and background filter, and is shown in Figure 2.

The general principle consists of two filters 6, 7, the foreground B filter 6 which is non adaptive, but whose coefficients are programmable, and a background adaptive B filter 7 whose coefficients are adaptive.

There is a discriminator 8 which compares the performance of each filter 6,7 and transfers the tap coefficients from the adaptive filters to non adaptive filter 6 if it is found that the adaptive filter gives a consistently better performance.

A technique that can be used to determine when the background filter 7 is giving better performance than the foreground filter 6 is to compare the mean signal level coming from the two filters, and if the signal level from the background filter 7 is consistently lower than the foreground filter 6 because of a lower level of echo, then it is deemed that the background filter 7 is giving better performance than the foreground filter 6 and the coefficients that determine the performance of the background filter 7 are transferred to the foreground filter 6.

Two conditions have been found where the technique described results in spurious coefficients being generated and transferred to the foreground filter causing poor trans-hybrid loss which can severely degrade the system transmission performance. There are:

a) Far end single tone with no near end signal.

b) Near end single tone with poor trans-hybrid loss at the far end.

Under condition (a), the least mean squares algorithm (LMS) used in the filter has very little frequency information available due to the single tone input and the tap values calculated will give good trans-hybrid loss at this frequency but can give trans-hybrid gain at other frequencies.

For condition (b), the algorithm will adapt such that the echo signal from the far end is used to cancel out the original outgoing signal from the near end. This is not a valid thing to attempt to do, because as soon as any coefficients generated this way are transferred to the foreground filter, the amplitude and phase of the outgoing signal, and therefore the returning echo signal will change and cancellation will not take place. The net effect in this case is usually to produce a set of coefficients that give very poor performance.

In many applications, the FIR filter that performs the echo cancellation is operating at a sampling frequency that is significantly greater than twice the maximum frequency of the signal to which it is adapting. This means that the filter has a greater bandwidth than is strictly necessary and there is redundancy in the coefficient values, that is, there is a large set of coefficient values that are capable of implementing the required performance in the band of interest.

For example, a typical telephony application would involve signals with a bandwidth up to just under 4 KHz, but use an FIR filter with a sampling frequency of 16KHz, giving a bandwidth of 8 KHz.

If all the coefficients are allowed to adapt then there is not sufficient information in the speech signal to adequately define the optimum coefficient values, which as a consequence, tend to drift around in a fairly arbitrary way. This can result in the generation of set of coefficients which are a long way from their optimum value, and which the adaption algorithm is unable to return to the optimum value using the information available in the speech signal.

The solution is to only allow a subset of the coefficients to adapt, where the subset is chosen so that it is still possible to get good performance in the bandwidth of interest. In the case of a filter operating at 16KHz, with a signal bandwidth of only 4KHz, it is only necessary to allow alternate coefficients to adapt, giving an effective adaptive bandwidth of 4KHz.

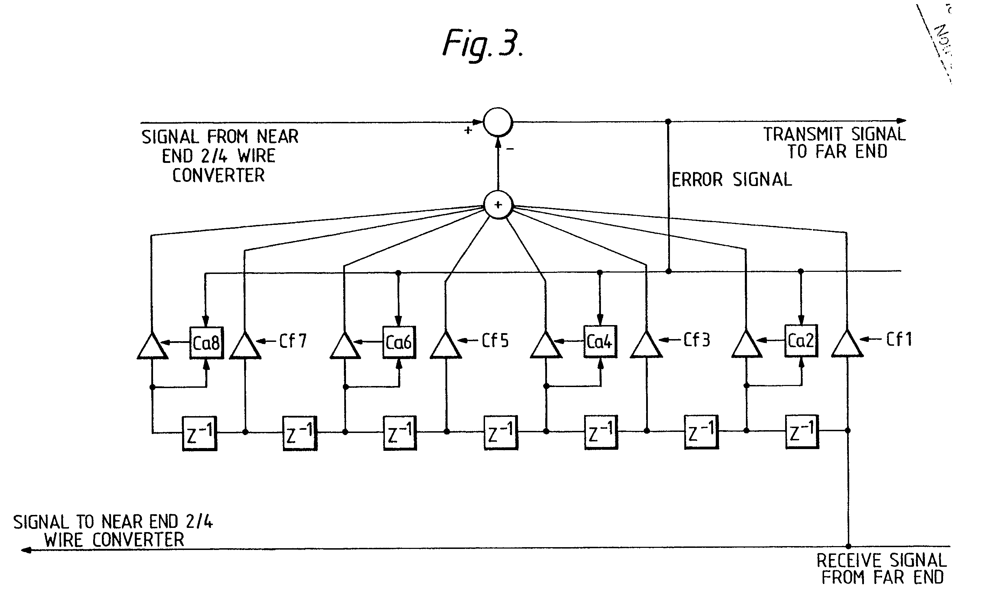

Such prior art arrangement is shown in Figure 3, where CF1, 3, 5 and 7 are the fixed, i.e. non-adaptive coefficients, and Ca2, 4, 6 and 8 are the adaptive coefficients, where the coefficient value is modified in order to minimise the level of the transmit or error signal, using an algorithm such as the least mean squares algorithm.

This technique is valid for conventional single filter adaptive systems, and systems based on the dual filter foreground/background approach.

Accordingly, an aim of the present invention is to provide a way of restricting the range of values that the background filter coefficients can take, to those which would give satisfactory performance, and preventing the generation of spurious sets of coefficients to overcome the problem.

According to the present invention, there is provided an adaptive finite impulse response filter comprising a foreground non adaptive filter and a background adaptive filter, wherein the background adaptive filter includes N-tap stages, of which X tap stages, where X is less than N, have their coefficient values applied to a summator, the output of which is connected to a comparator and compared with a predetermined constant K to produce a signal which is applied to switch means arranged to control an output of a disciminator, the discriminator being arranged to monitor the performance of the foreground and background filters, and characterised in that the switch means operates to prevent the coefficient values of the foreground filter being updated by the background filter when the coefficient values of the background filter are unsatisfactory.

Embodiments of the present invention will now be described with reference to the accompanying drawings, wherein:

Figure 1 shows a subscriber interface incorporating prior art adaptive balancing;

Figure 2 shows a prior art adaptive balancing filter incorporating foreground and background filters;

Figure 3 shows a prior art adaptive B filter with alternate taps adapting;

Figure 4 shows a typical impulse response of a 2/4 wire converter, and coefficient values produced by an adaptive B filter operating correctly;

Figure 5 shows a typical impulse response of a 2/4 wire converter, and coefficient values produced by an adaptive B filter operating incorrectly;

Figure 6 shows the derivation of an update enable signal of an adaptive filter with all taps adapting;

Figure 7 shows the derivation of an update enable signal of an adaptive filter with alternate taps adapting, and;

Figure 8 shows the use of the update enable signal to control a foreground/background adaptive filter.

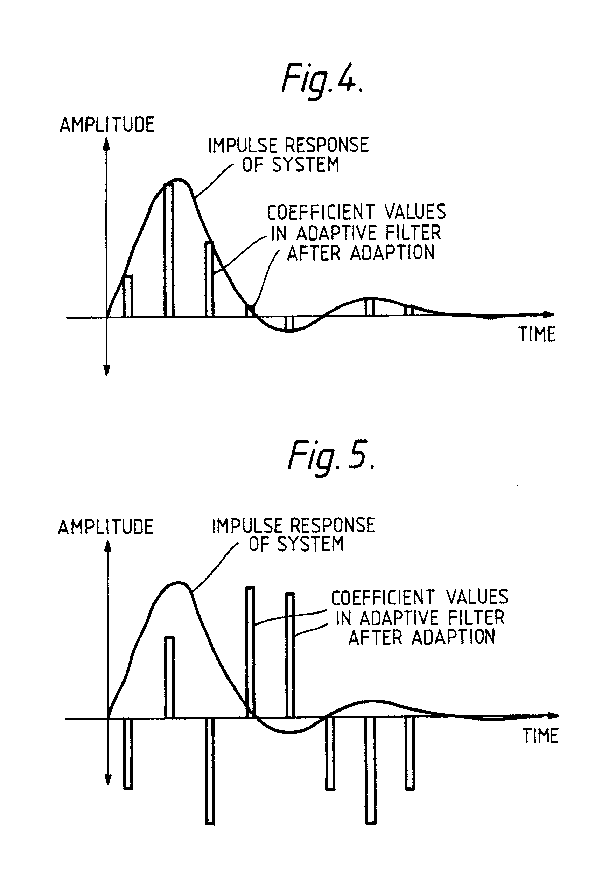

Referring to Figures 4, 5, 6, 7 and 8 an adaptive FIR filter is described which provides limits on the maximum absolute value that coefficient or sums of coefficients can take. This technique can only be applied when the dual filter foreground/background design as described above is used, and can be used in conjunction with the technique described above with reference to Figure 3.

When the adaptive filter is operating normally, the coefficients will take values which reflect the impulse response of the system to which it is adapting. The impulse response will typically have the characteristic that there is a lot of energy at the start of the impulse, then the response dies away quickly afterwards, as shown in Figure 4. The coefficient values will therefore reflect this characteristic with large values for small time delays, and increasingly small values as the time delay increases.

The technique will only operate correctly in systems where the signal bandwidth is significantly less than the filter bandwidth if the subsampling technique is used.

It is a characteristic of the adaptive filter when it is not operating correctly that it will produce unusually large coefficient values for the coefficients corresponding to large delays. With these values, the trans-hybrid loss will be very poor. This is shown in Figure 5.

The present invention produces a sum of the magnitude of all, or a restricted number of the coefficients and compares this against a preset limit. If the sum exceeds this value, then the coefficient set is discarded.

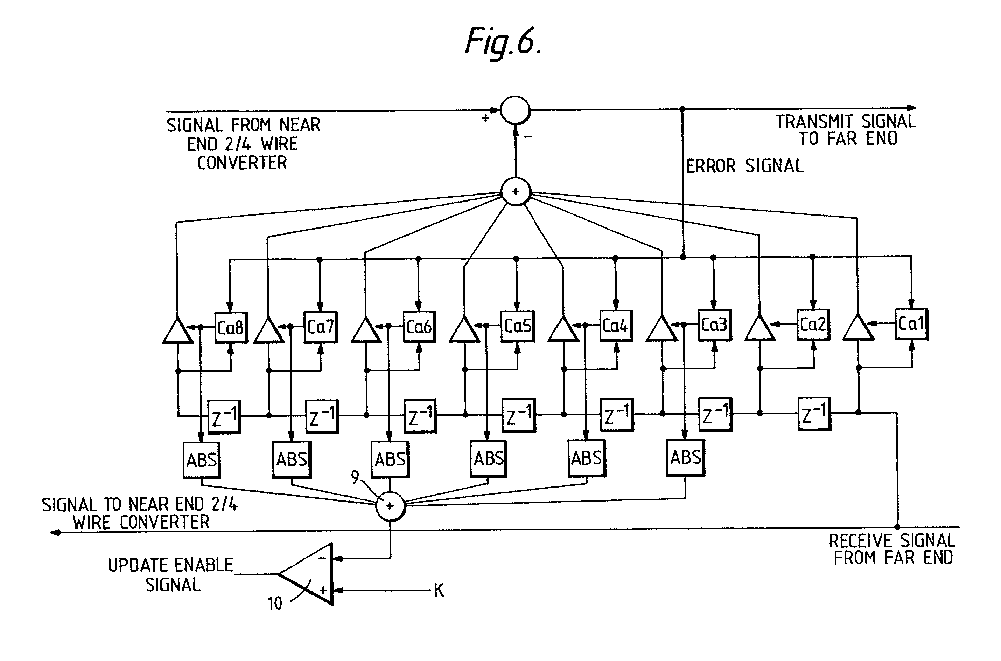

Figure 6 shows how the coefficients would be summed in a system where all the coefficients are able to be adapted. In the diagram, the FIR filter is eight taps long, Ca1 - Ca8. In the general case it would be N taps, where N is determined by system considerations. The sum of the magnitudes of the last six coefficient values of taps Ca3-Ca8 is calculated by summator 9; and applied to the negative input of the comparator 10. In the general case, the last X taps would be used, where X is determined by consideration of the range of impulse responses to which the adaptive filter will have to adapt, and could lie in the range 1 to N. The sum is then compared with a predetermined value K, where K is again determined by consideration of the range of impulse responses to which the system will have to adapt. The output of the comparator 10 is the adaption enable signal which determines whether adaption should proceed or not in the system.

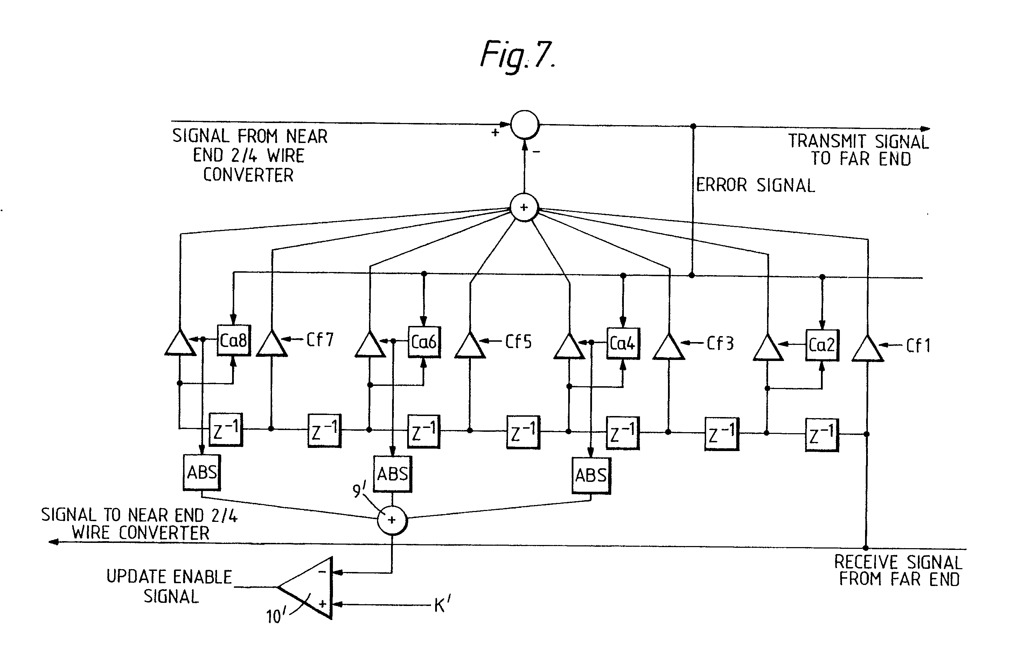

Figure 7 shows how the coefficients would be summed in a system where only a subset of the coefficients are allowed to adapt. The coefficients that do not adapt are ignored, and the sum of the magnitudes of the last $X'$ taps of the filter is calculated by summator $9'$ and compared with a predetermined constant $K'$ by comparator $10'$. In the specific case shown in Figure 7, $X' = 3$, but could lie in the range 1 to N/2.

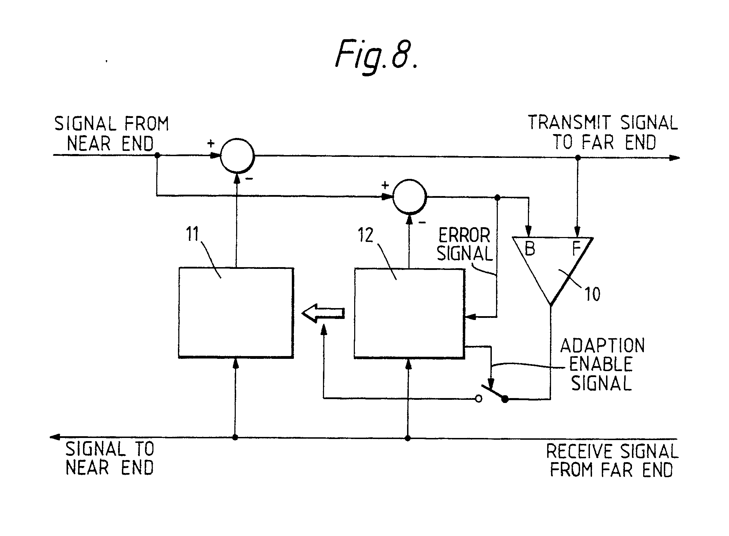

Figure 8 shows how the adaption enable signal is used to control the updating of the coefficients in a two filter foreground/background filter system. The discriminator 10 continues to compare the performance of the foreground B filter 11 and the background adaptive B filter 12. The adaption enable signal is used to gate the output of the filter so preventing foreground filter coefficient update when the coefficients in the background filter are found to be unsatisfactory. Updates will continue to be suppressed until the adaptive algorithm has restored the coefficients to a more satisfactory set of values.

The above description is not intended to be limited to the embodiments described above. It will be appreciated by those skilled in the art that alternative embodiments or modifications could be envisaged which fall within the scope and spirit of the present invention.

## Claims

1. An adaptive finite impulse response filter comprising a foreground non adaptive filter and a background adaptive filter, wherein the background adaptive filter includes N tap stages of which X tap stages, where X is less than N, have their coefficient values applied to a summator, the output of which is connected to a comparator and compared with a predetermined constant K to produce a signal which is applied to switch means arranged to control an output of a discriminator, the discriminator being arranged to monitor the performance of the foreground and background filters, and characterised in that the switch means operates to prevent the coefficient values of the foreground filter being updated by the background filter when the coefficient values of the background filter are unsatisfactory.

2. An adaptive filter as claimed in Claim 1, wherein the background filter is arranged to have all taps adapting.

3. An adaptive filter as claimed in Claim 1, wherein the background filter is arranged to have alternate taps adapting.

*Fig.1.*

*Fig.2.*

Fig.3.

SIGNAL FROM NEAR
END 2/4 WIRE
CONVERTER

TRANSMIT SIGNAL
TO FAR END

ERROR SIGNAL

Ca8   Cf7   Ca6   Cf5   Ca4   Cf3   Ca2   Cf1

$Z^{-1}$   $Z^{-1}$   $Z^{-1}$   $Z^{-1}$   $Z^{-1}$   $Z^{-1}$   $Z^{-1}$

SIGNAL TO NEAR END 2/4
WIRE CONVERTER

RECEIVE SIGNAL
FROM FAR END

EP 0 422 796 A2

# Fig.4.

# Fig.5.

Fig.6.

Fig.7.

SIGNAL FROM NEAR
END 2/4 WIRE
CONVERTER

TRANSMIT SIGNAL
TO FAR END

ERROR SIGNAL

Ca8 Cf7 Ca6 Cf5 Ca4 Cf3 Ca2 Cf1

$Z^{-1}$ $Z^{-1}$ $Z^{-1}$ $Z^{-1}$ $Z^{-1}$ $Z^{-1}$ $Z^{-1}$

ABS ABS ABS

9'

SIGNAL TO NEAR END 2/4
WIRE CONVERTER

UPDATE ENABLE
SIGNAL

10'

K'

RECEIVE SIGNAL
FROM FAR END

EP 0 422 796 A2

# Fig.8.